# EUROPEAN PATENT SPECIFICATION

(11) **EP 0 399 529 B1**
(45) Date of publication and mention of the grant of the patent: **04.11.1998**
(21) Application number: 90109896.2
(22) Date of filing: 23.05.1990
(51) Int. Cl.: H01L 21/336

(54) **Semiconductor device manufacturing method and semiconductor device manufactured thereby**
Verfahren zur Herstellung eines Halbleiterbauelementes und so hergestelltes Halbleiterbauelement
Méthode de fabrication d'un élément semi-conducteur, et élément semi-conducteur ainsi fabriqué

(30) Priority: 24.05.1989 JP 128652/89
(43) Date of publication of application: 28.11.1990
(73) Proprietor: KABUSHIKI KAISHA TOSHIBA, Kawasaki-shi, Kanagawa-ken 210 (JP)
(72) Inventor: Kizu, Tatsuki, Kohoku-ku, Yokohama-shi, Kanagawa-ken (JP); Shimada, Shinichi, Isogo-ku, Yokohama-shi, Kanagawa-ken (JP); Kobayashi, Kiyoshi, Kawasaki-shi, Kanagawa-ken (JP)
(74) Representative: Lehn, Werner, Dipl.-Ing.

(56) References cited:
- EP-A- 0 088 992
- EP-A- 0 127 725
- EP-A- 0 218 408
- DE-A- 3 530 065

## Description

### BACKGROUND OF THE INVENTION

### 1. Field of the Invention:

This invention relates to a method for manufacturing a semiconductor device and a semiconductor device manufactured thereby, and more particularly to a method for eliminating spacer in part on a semiconductor substrate by an etching process, preventing any damage to the semiconductor substrate and gates thereon.

### 2. Description of the Related Art:

Heretofore, a non-doped polysilicon spacer has been in ordinary use to manufacture a MOS transistor having an LDD structure; such a spacer is formed by forming polysilicon gates on a semiconductor substrate after oxidizing the gates subsequently, by adding an impurity of a low concentration to the semiconductor substrate and by accumulating polysilicon layer on the after-oxide film.

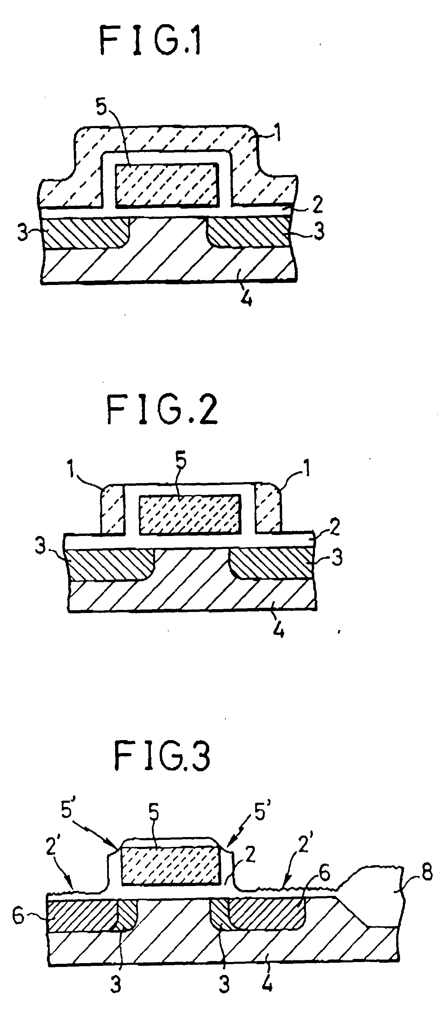

FIG. 1 shows shows a semiconductor device manufactured by this conventional method. The semiconductor substrate 4 includes electrode regions 3 of a low impurity concentration. A polysilicon gate 5 is formed on the substrate 4, with a gate oxide film 2 sandwiched between the polysilicon gate 5 and the substrate 4. A non-doped polysilicon layer 1 is formed over the gate oxide film 2.

The resulting polysilicon layer 1 is etched by the RIE (reactive ion etching) method and non-doped polysilicon spacers 1 are formed at the gate sidewalls as shown in FIG. 2. Then an impurity of a high concentration is added in the semiconductor substrate to form high impurity concentration regions 6 whose extent is determined by the polysilicon spacers. Finally, the polysilicon spacer 1 is further etched by the CDE (chemical dry etching) method to form an LDD structure.

According to the conventional method, however, there has been a disadvantage that the spacer 1 can only be inadequately eliminated in the CDE process due to the composition of the spacer 1. Specifically, since the spacer 1 consists exclusively of a non-doped polysilicon, its etching speed is relatively low. Thus, the difference in etching speed between the polysilicon spacer 1 and the after-oxide film 2 made of SiO₂ would be relatively small to adequately eliminate a desired part of the polysilicon spacer 1.

In other words, if a long time is given for the etching process to adequately eliminate the polysilicon spacer 1, the etching process would excessively proceed so as to partly etch even the oxide film 2, thus producing a damaged portion 2' as shown in FIG. 3. Further, the etching action could occasionally reach the polysilicon gate 5 to cause damage, thus producing a damage portion 5'.

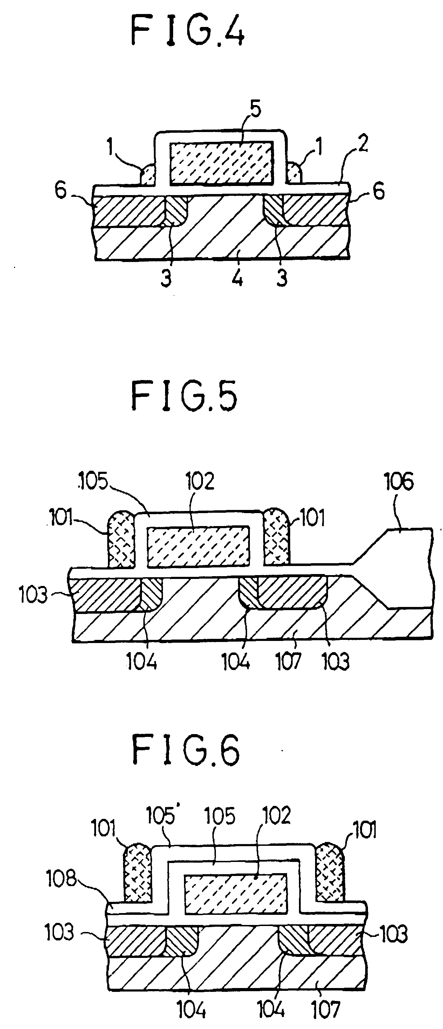

To the contrary, if the etching time is shortened to avoid such damage, the spacer 1 would be inadequately eliminated, leaving some unnecessary spacer part as shown in FIG. 4. This residual spacer 1 would act as a floating gate which impairs the transistor property. If the polysilicon gate 5 has a reverse-taper shape, this problem is more intense so that more of the spacer is apt to remain.

Therefore, for the desired elimination of the spacer 1, it has heretofore been a common practice to keep the etching time as long as possible to minimize the margin of the spacer 1 to protect the after-oxide film.

Further, since not only the after-oxide film 2 of the gate but also the field oxide film 8 would be etched during the etching of the polysilicon spacer 1, it is necessary to keep a margin of the field oxide film 8 at the stage of designing. This, like the so-called bird's beak, has been an obstacle to the high integration of the semiconductor device.

### SUMMARY OF THE INVENTION

It is therefore an object of the present invention to provide a semiconductor device manufacturing method for adequately eliminating the spacer and preventing the gate and the semiconductor substrate from being damaged during the etching process.

Another object of the invention is to provide a semiconductor device which is manufactured by the method described above.

According to the invention, there is provided a method of manufacturing a semiconductor device, comprising the steps of:
preparing a semiconductor substrate having an after-oxide film which overlies said semiconductor substrate and covers a polysilicon gate on said after-oxide film, and a polysilicon layer formed on said after-oxide film;
forming electrode regions of low impurity concentration in said semiconductor substrate;
ion-implanting an impurity to dope the polysilicon layer, the impurity being such as to increase the etching rate of the doped layer under chemical dry etching;
exposing the doped polysilicon layer to reactive ion etching to remove the polysilicon layer except at the sidewalls of the gate, thereby forming doped polysilicon spacers there;
ion-implanting another impurity into the semiconductor substrate so as to form other electrode regions having a high impurity concentration and of an extent determined by said polysilicon spacers; and
removing the polysilicon spacers by chemical dry etching.

By this method, the time for etching the polysilicon spacer by chemical dry etching, which can be phosphorus-doped, can be reduced nearly half the time for etching the semiconductor substrate so that the polysilicon spacer can be adequately eliminated without damaging the gate insulating film.

Many other advantages, features and additional objects of the present invention will become manifest to those skilled in the art upon making reference to the detailed description and the accompanying drawings in which certain preferred embodiments of the present invention are shown by way of illustrative example.

### BRIEF DESCRIPTION OF THE DRAWINGS

Fig. 1 is a fragmentary cross-sectional view of a semiconductor device in which a polysilicon layer has been formed according to a conventional method;
FIG. 2 is a view similar to FIG. 1, showing the semiconductor device in which the polysilicon layer has been ideally etched to form polysilicon spacers at the gate sidewalls;
FIG. 3 shows a conventional art problem with the semiconductor device of FIG. 2 in which the after-oxide film can be damaged during the etching process;
FIG. 4 is a view similar to FIG. 3, showing another conventional problem in which the unnecessary part of the spacer of FIG. 2 can be eliminated only incompletely;
FIG. 5 is a fragmentary cross-sectional view of a semiconductor device, showing one of manufacturing steps according to a first embodiment of the present invention; and
FIG. 6 is a view similar to FIG. 5, showing one of the manufacturing steps according to a second embodiment.

### DETAILED DESCRIPTION OF THE EMBODIMENTS

The principles of the present invention are particularly useful when embodied in a semiconductor device such as shown in FIG. 5.

In FIG. 5, a polysilicon spacer 101 is formed on the oxide film 105 on a semiconductor substrate 107 at each gate sidewall, so as to define electrode regions 103 of a high impurity concentration. To form the polysilicon spacer a polysilicon layer is deposited on the oxide film 105 formed on a semiconductor substrate 107, similarly to the polysilicon layer 1 formed in the conventional process shown in FIG. 1. The polysilicon layer 101 is added with phosphorus by ion-implantation (P-doped) and is annealed by using N₂ so as to thermally diffuse phosphorus. Thereafter, the polysilicon layer 101 is etched by RIE (reactive ion etching), so that P-doped polysilicon spacers 101 will be formed, as shown in FIG. 5.

When an N-channel transistor is to be made, the after-oxide film 105 is formed first, and phosphorus ions are ion-implanted to the substrate to form electrode regions 104 having a low impurity concentration. Then, the P-doped polysilicon spacer 101 will be formed. Thereafter, arsenic ions are ion-implanted into the substrate 107 to form electrode regions 103 having a high impurity concentration, so that the N-channel transistor having the LDD structure will be formed.

The etching time to eliminate the P-doped polysilicon spacers will be reduced to half the time required to eliminate non-doped polysilicon spacer. As a result, the scraping depth of the after-oxide film 105 and the field oxide film 106 will be reduced nearly half compared with the conventional method.

FIG. 6 shows another embodiment of the present invention, in which an after-oxidization process is applied twice to form a first after-oxide film 105 and a second after-oxide film 105' prior to forming the P-doped polysilicon spacer 101. The first after-oxide film 105 is made dense by applying thereto dry O₂ of 900° so as to prevent the oxide film from being shaped like a bird's beak. The second oxide film 105' is subject to BOX-oxidization at 850° in order to increase the thickness of the oxide film in the vicinity of the polysilicon gate. As a result, even when the polysilicon film is as thick as the polysilicon film of the prior art, the process margin can be increased substantially, thereby preventing the semiconductor substrate from being damaged during the etching process to form the polysilicon spacer.

In the illustrated embodiments, the polysilicon layer is doped by ion-implanting phosphorus ions and annealed by using N₂ by way of example. Phosphorus also can be diffused by using POCl₃. In the second embodiment, the after-oxidization process is separately carried out twice, but can be performed in series.

According to the present method, the P-doped polysilicon spacer can be chemically dry etched at a speed which is about two times the speed of the etching process applied to the non-doped polysilicon spacer in the conventional process. In addition, the scraped depth of the after-oxide film and the field oxide film will be reduced to half the depth to be scraped in the convectional method. As a result, the process margin will be increased, which will enable semiconductor devices to be manufactured as economically and efficiently as possible.

In addition, the field oxide film is protected against any damage caused by the etching process, with the result that the semiconductor device is susceptible to high integration.

## Claims

1. A method of manufacturing a semiconductor device, comprising the steps of:
preparing a semiconductor substrate (107) having a gate oxide film (105) thereon, a polysilicon gate (102) on said gate oxide film (105), an after-oxide film (105) which overlies said semiconductor substrate (107) and said polysilicon gate (102), and a polysilicon layer formed on said after-oxide film (105);
forming electrode regions (104) of low impurity concentration in said semiconductor substrate (107);
ion-implanting an impurity to dope the polysilicon layer the impurity being such as to increase the etching rate of the doped layer;
effecting thermal diffusion of the implanted impurity;
exposing the doped polysilicon layer to reactive ion etching to remove the polysilicon layer except at the sidewalls of the gate, thereby forming doped polysilicon spacers (101) there;
ion-implanting another impurity into the semiconductor substrate (107) so as to form other electrode regions (103) having a high impurity concentration and of an extent determined by said polysilicon spacers (101); and
removing the polysilicon spacers (101) by etching.

2. The method of claim 1, wherein the first-mentioned impurity is phosphorus.

3. The method of claim 1 or 2, wherein the polysilicon layer is formed by deposition of polysilicon.

4. The method of claims 1, 2 or 3, further comprising the step of effecting the thermal diffusion using N₂ so as to thermally diffuse the impurity prior to exposing the doped polysilicon layer (101) to the reactive ion etching.

5. The method of any preceding claim, wherein said another impurity is arsenic.

6. The method of any preceding claim wherein the after-oxide film (105) is formed as a dual film consisting of first and second silicon after-oxide films (105, 105').

7. The method of claim 6, wherein the first after-oxide film (105) is made dense by thermal treatment in a dry oxygen atmosphere whereas the second silicon after-oxide film (105') is made thicker by being subjected to BOX oxidation.

## Patentansprüche

1. Ein Verfahren zur Herstellung einer Halbleitereinrichtung, umfassend die Schritte:
Herrichten eines Halbleitersubstrats (107) mit einem Gate-Oxidfilm (105) darauf, einem Polysiliziumgate (102) auf dem Gate-Oxidfilm (105), einem Nach-Oxidfilm (105), der auf dem Halbleitersubstrat (107) und dem Polysiliziumgate (102) liegt, und einer Polysiliziumschicht, die auf dem Nach-Oxidfilm (105) gebildet ist;
Bilden von Elektrodenbereichen (104) mit geringer Verunreinigungskonzentration in dem Halbleitersubstrat (107);
Ionenimplantation einer Verunreinigung zur Dotierung der Polysiliziumschicht, wobei die Verunreinigung so ist, daß die Ätzrate der dotierten Schicht erhöht wird;
Ausführen einer thermischen Diffusion der implantieren Verunreinigung;
Aussetzen der dotierten Polysiliziumschicht zu einem reaktiven Ionenätzen um die PolySiliziumschicht außer an den Seitenwänden des Gates zu entfernen, um dadurch dort dotierte Polysiliziumspacer (101) zu bilden;
Ionenimplantation einer anderen Verunreinigung in das Halbleitersubstrat (107) zur Bildung anderer Elektrodenbereiche (103) mit einer hohen Verunreinigungskonzentration, mit einem Ausmaß, daß mittels den Polysiliziumspacern (101) bestimmt wird; und
Entfernen der Polysiliziumspacer (101) mittels Ätzen.

2. Verfahren nach Anspruch 1 **dadurch gekennzeichnet, daß** die zuerst angegebene Verunreinigung Phosphor ist.

3. Verfahren nach Anspruch 1 oder 2 **dadurch gekennzeichnet, daß** die Polysiliziumschicht mittels Ablagerung von Polysilizium gebildet wird.

4. Verfahren nach einem der Ansprüche 1, 2 oder 3 **dadurch gekennzeichnet,daß** es des weiteren den Schritt des Ausführens einer thermischen Diffusion unter Verwendung von N₂ umfaßt, um thermisch die Verunreinigung vor dem Aussetzen der dotierten Polysiliziumschicht (102) zu dem reaktiven Ionenätzen, thermisch zu zerstreuen.

5. Verfahren nach einem der vorhergehenden Ansprüche, **dadurch gekennzeichnet, daß** die andere Verunreinigung Arsen ist.

6. Verfahren nach einem der vorhergehenden Ansprüche, **dadurch gekennzeichnet, daß** der Nach-Oxidfilm (105) ein Doppelfilm ist, der aus einem ersten und einem zweiten Silizium Nach-Oxidfilm (105, 105') besteht.

7. Verfahren nach Anspruch 6, **dadurch gekennzeichnet, daß** der erste Nach-Oxidfilm (105) mittels thermischer Behandlung in einer trockenen Sauerstoffatmosphäre dicht gemacht wird, wohingegen der zweite Silizium Nach-Oxidfilm (105') und mittels Aussetzen zu einer BOX Oxidation dicker gemacht wird.

## Revendications

1. Procédé de fabrication d'un dispositif à semi-conducteur comprenant les étapes consistant à :
préparer un substrat semi-conducteur (107) ayant un film d'oxyde épais (105) sur celui-ci, une grille en polysilicium (102) sur ledit film d'oxyde épais (105), un film après oxydation (105) qui recouvre ledit substrat semi-conducteur (107) et ladite grille en polysilicium (102) et une couche de polysilicium formée sur ledit film après oxydation (105) ;
former des régions d'électrode (104) de faible concentration d'impuretés dans ledit substrat semi-conducteur (107) ;
implanter par ions une impureté afin de doper la couche de polysilicium, l'impureté étant telle qu'elle puisse augmenter la vitesse d'attaque de la couche dopée ;
effectuer une diffusion thermique de l'impureté à implanter ;
exposer la couche de polysilicium dopé à une attaque par ions réactive afin d'enlever la couche de polysilicium sauf au niveau des parois latérales de la grille, formant de ce fait des séparateurs en polysilicium dopé (101) à cet endroit ;
implanter par ions d'autres impuretés dans le substrat semi-conducteur (107) de façon à former d'autres régions d'électrode (103) ayant une concentration élevée d'impuretés et d'une étendue déterminée par lesdits séparateur en polysilicium (101) ; et
enlever les séparateurs en polysilicium (101) par attaque.

2. Procédé selon la revendication 1, dans lequel l'impureté est mentionnée en premier est du phosphore.

3. Procédé selon la revendication 1 ou 2, dans lequel la couche en polysilicium est formée par dépôt de polysilicium.

4. Procédé selon la revendication 1, 2 ou 3 comprenant de plus l'étape consistant à effectuer la diffusion thermique en utilisant N₂ de façon à diffuser thermiquement l'impureté avant d'exposer la couche en polysilicium dopé (101) à l'attaque par ions réactive.

5. Procédé selon l'une quelconque des revendications précédentes, dans lequel ladite autre impureté est de l'arsenic.

6. Procédé selon l'une quelconque des revendications précédentes, dans lequel le film après oxydation (105) est formé comme un film double qui est constitué de premier et second films de silicium après oxydation (105, 105').

7. Procédé selon la revendication 6, dans lequel le premier film après oxydation (105) est rendu plus dense par traitement thermique dans une atmosphère d'oxygène sec tandis que le second film après oxydation de silicium est rendu plus élevé en étant soumis à une oxydation BOX.
